# EUROPEAN PATENT SPECIFICATION

(11) **EP 1 508 834 B1**
(45) Date of publication and mention of the grant of the patent: **06.04.2016**
(21) Application number: 04254005.4
(22) Date of filing: 02.07.2004
(51) Int. Cl.: G03F 7/00, G03F 7/004, G03F 7/038

(54) **Nanoparticle-filled stereolithographic resins**
Mit Nanopartikeln gefüllte stereolithographische Harze
Résines stéréolithographiques garnies de nanoparticules

(30) Priority: 19.08.2003 US 644299
(43) Date of publication of application: 23.02.2005
(73) Proprietor: 3D Systems, Inc., Rock Hill, SC 29730 (US)
(72) Inventor: Steinmann, Bettina, 1724 Praroman (CH); Steinmann, Alfred, 1724 Praroman (CH)
(74) Representative: Hess, Peter K. G.

(56) References cited:
- EP-A- 0 565 403
- EP-A- 0 831 373
- EP-A- 1 327 911
- US-A1- 2002 051 942
- US-A1- 2003 149 124

## Description

### BACKGROUND OF THE INVENTION

### 1. Field of the Invention

The present invention relates to selected liquid, radiation-curable compositions which are particularly suitable for the production of three-dimensional articles by stereolithography as well as a process for the production of cured articles and the cured three-dimensional shaped article themselves. In particular, this invention relates to liquid, radiation-curable resin compositions containing silica-type nanoparticle fillers from which cured three-dimensional shaped articles can be built up.

### 2. Brief Description of Art

The production of three-dimensional articles of complex shape by means of stereolithography has been known for a relatively long time. In this technique the desired shaped article is built up from a liquid, radiation-curable composition with the aid of a recurring, alternating sequence of two steps (a) and (b); in step (a), a layer of the liquid, radiation-curable composition, one boundary of which is the surface of the composition, is cured with the aid of appropriate radiation, generally radiation produced by a preferably computer-controlled laser source, within a surface region which corresponds to the desired cross-sectional area of the shaped article to be formed, at the height of this layer, and in step (b) the cured layer is covered with a new layer of the liquid, radiation-curable composition, and the sequence of steps (a) and (b) is repeated until a so-called green model of the desired three-dimensional shape is finished. This green model is, in general, not yet fully cured and must therefore, normally, be subjected to post-curing.

The mechanical strength of the green model (modulus of elasticity, fracture strength), also referred to as green strength, constitutes an important property of the green model and is determined essentially by the nature of the stereolithographic resin composition employed. Other important properties of a stereolithographic resin composition include a high sensitivity for the radiation employed in the course of curing and a minimum curl factor, permitting high shape definition of the green model. In addition, for example, the procured material layers should be readily wettable by the liquid stereolithographic resin composition, and, of course, not only the green model but also the ultimately cured shaped article should have optimum mechanical properties.

Another requirement that has recently become a high priority for stereolithography users is the high temperature performance of cured articles produced by stereolithography. It is usually measured by the Heat Deflection Temperature (HDT) or Glass Transition Temperature (Tg). The HDT value is determined by the ASTM method D648 applying a load of 66 psi. For certain applications, e.g. wind tunnel testing, a high stiffness of the material is required. The stiffness is measured by the flexural modulus or tensile modulus.

In order to achieve the desired balance of properties, different types of resin systems have been proposed. For example, radical-curable resin systems have been proposed. These systems generally consist of one or more (meth)acrylate compounds (or other free-radical polymerizable organic compounds) along with a free-radical photoinitiator for radical generation. U.S. Patent No. 5,418,112 describes one such radical-curable system.

Another type of resin composition suitable for this purpose is a dual type system that comprises (i) epoxy resins or other types of cationic polymerizable compounds; (ii) cationic polymerization initiator; (iii) acrylate resins or other types of free radical polymerizable compounds; and (iv) a free radical polymerization initiator. Examples of such dual systems are described in U.S. Patent No. 5,434,196.

A third type of resin composition useful for this application also includes (v) reactive hydroxyl compounds such as polyether-polyols. Examples of such hybrid systems are described in U.S. Patent No. 5,972,563.

It is also well known to add filler materials to all three types of these compositions. Such fillers included reactive or non-reactive, inorganic or organic, powdery, fibrous or flaky materials. Examples of organic filler materials are polymeric compounds, thermoplastics, core-shell, aramid, Keviar, nylon, crosslinked polystyrene, crosslinked poly (methyl methacrylate), polystyrene or polypropylene, crosslinked polyethylene powder, crosslinked phenolic resin powder, crosslinked urea resin powder, crosslinked melamine resin powder, crosslinked polyester resin powder and crosslinked epoxy resin powder. Examples of inorganic fillers are glass or silica beads, calcium carbonate, barium sulfate, talc, mica, glass or silica bubbles, zirconium silicate, iron oxides, glass fiber, asbestos, diatomaceous earth, dolomite, powdered metals, titanium oxides, pulp powder, kaoline, modified kaolin, hydrated kaolin metallic filers, ceramics and composites. Mixtures of organic and/or inorganic fillers can be used.

Separately, European Patent No. 1,029,651 B1 teaches the use of metal-type nanoparticles as a filler for stereolithographic resins.

Specifically, this European Patent added nano-metal particles (e.g. titanium nanoparticles) to achieve high conductivity properties and for forming tool parts with strong physical and/or mechanical properties. This European Patent does not teach or suggest any particular stereolithographic resin formulation with which these nano-metal particles could be used.

In addition, Hanse Chemie describe in their product literature that radiation-cured pure (meth)acrylate resins filled with silica-nanoparticles have been made. That literature does not suggest or otherwise indicate that such nanofilled (meth)acrylates would be useful in making three-dimensional objects by stereolithographic processes.

Despite all previous attempts, there exists a need for liquid radical, dual and/or hybrid stereolithographic compositions capable of producing cured articles that possess both high temperature resistance and high stiffness. The present invention provides a solution according to the subject matter of the Independent claims.

### BRIEF SUMMARY OF THE INVENTION

Therefore, one aspect of the present invention is directed to a process for forming three-dimensional articles by stereolithography, said process comprising the steps:
1) coating a thin layer of a liquid radiation-curable composition onto a surface; said composition Including at least one filler comprising silica-type nanoparticles suspended In the radiation curable composition;
2) exposing said thin layer imagewise to actinic radiation to form an imaged cross-section, wherein the radiation Is of sufficient intensity to cause substantial curing of the thin layer in the exposed areas;
3) coating a thin layer of the composition onto the previously exposed imaged cross-section;
4) exposing said thin layer from step (3) imagewise to actinic radiation to form an additional imaged cross-section, wherein the radiation is of sufficient intensity to cause substantial curing of the thin layer in the exposed areas and to cause adhesion to the previously exposed imaged cross-section;
5) repeating steps (3) and (4) a sufficient number of times in order to build up the three-dimensional article.

This stereolithographic process employs a radiation-curable composition according to the subject matter of independent claim 1.

Another aspect of the present invention is directed to a liquid radiation-curable composition useful for the production of three-dimensional articles by stereolithography, according to the subject matter of independent claim 1.

The silica-type nanoparticle-filled stereolithographic resin compositions that are used in the stereolithographic processes of the present invention have several advantages over other types of filled stereolithographic resins made by prior art methods. They are optically transparent because of the small size of the particles and therefore don't scatter light, so that the resolution is the same as for unfilled resins. The nanoparticles don't sediment, the compositions stay homogeneous and there Is no need to add additional stirring equipment to the stereolithography apparatus. The viscosity of the nanoparticle filled resin compositions is in the same range as for unfilled resins and the recoating step can be performed as usual.

### DETAILED DESCRIPTION OF THE INTENTION

The term "(meth)acrylate" as used in the present specification and claims refers to both acrylates and methacrylates.

The term "liquid" as used in the present specification and claims is to be equated with "liquid at room temperature" which is, in general, a temperature between about 5°C and about 30°C.

The term "microparticles" as used in the present specification and claims refers to filler particles having an average particle size in the range from about 1 to about 100 microns, as measured by light scattering methods.

The term "nanoparticles" as used in the present specification and claims refers to filler particles having an average particle size in the range of about 10 to about 50 nanometers, as measured by light scattering methods such as by the small angle neutron scattering method.

The term "silica-type nanoparticles" as used in the present specification and claims refers to silica-containing particles having an average particle size in the range of from about 10 to about 50 nanometers as measured by light scattering methods, such as by the small angle neutron scattering method.

The novel stereolithographic processes and resulting solid, cured three-dimensional products of the present invention use selected liquid radiation-curable compositions as the starting material for such processes. This starting material contains, in the broadest sense, a mixture of at least one free radical polymerizable organic substance; and at least one free radical photoinitiator; and a filler that includes silica-type nanoparticles that is suspended in the composition. The starting materials further contain at least one polymerizable organic substance, at least one cationic polymerizable photoinitiator, at least one hydroxyl-functional compound and optionally at least one microparticle filler.

The novel radiation-curable compositions of the present invention contain, in the broadest sense, a mixture of at least one free radical polymerizable organic substance; at least one free radical photoinitiator; a filler that includes silica-type nanoparticles that are suspended in the composition; and at least one cationic polymerizable photoinitiator. These compositions further contain at least one hydroxyl-functional compound and optionally at least one microparticle filler.

### (A) Free-Radical Polymerizing Organic Substance

The free radically curable component preferably comprises at least one solid or liquid poly(meth)acrylate, for example, mono-, di-, tri-, tetra- or pentafunctional monomeric or oligomeric aliphatic, cycloaliphatic or aromatic acrylates or methacrylates and mixtures thereof. The compounds preferably have a molecular weight of from about 100 to about 500.

Examples of suitable mono-functional aliphatic (meth)acrylate compounds include hydroxymethyl acrylate. Examples of cycloaliphatic (meth)acrylate compounds include cyclic trimethyol propane formal acrylate. Examples of di-functional aliphatic di-functional (meth)acrylate compounds include hexanedioldiacrylate and bisphenol A diglycidyl diacrylate.

Examples of suitable aliphatic poly(meth)acrylates having more than two unsaturated bonds in their molecules are the triacrylates and trimethacrylates of hexane-2,4,6-triol, glycerol or 1,1,1-trimethylolpropane, ethoxylated or propoxylated glycerol or 1,1,1-trimethylolpropane, and the hydroxyl-containing tri(meth)acrylates which are obtained by reacting triepoxide compounds, for example the triglycidyl ethers of said triols, with (meth)acrylic acid. It is also possible to use, for example, pentaerythritol tetraacrylate, bistrimethylolpropane tetraacrylate, pentaerythritol monohydroxytriacrylate or -methacrylate, or dipentaerythritol monohydroxypentaacrylate or -methacrylate.

It is additionally possible, for example, to use polyfunctional urethane acrylates or urethane methacrylates. These urethane (meth)acrylates are known to the person skilled in the art and can be prepared in a known manner by, for example, reacting a hydroxyl-terminated polyurethane with acrylic acid or methacrylic acid, or by reacting an isocyanate-terminated prepolymer with hydroxyalkyl (meth)acrylates to give the urethane (meth)acrylate.

Preferably, these free radical polymerizable compounds constitute about 5% to about 70% by weight of the radiation-curable composition; more preferably, about 10% to about 60% by weight.

Preferred free radical polymerizable compounds include mono-functional (meth)acrylate compounds such as hydroxymethyl methacrylate and cyclic trimethylol propane formal acrylate; di-functional (meth)acrylate compounds such as hexanediodiacrylate; tri-functional (meth)acrylate compounds such as trimethylol propane triacrylate; and urethane (meth)acrylate compounds such as aliphatic urethanediacrylate . It is also preferred to use combinations of such (meth)acrylate compounds.

### (B) Free Radical Polymerization Initiators

In the compositions according to the invention, any type of photoinitiator that forms free radicals when the appropriate irradiation takes place can be used. Typical compounds of known photoinitiators are benzoins, such as benzoin, benzoin ethers, such as benzoin methyl ether, benzoin ethyl ether, and benzoin isopropyl ether, benzoin phenyl ether, and benzoin acetate, acetophenones, such as acetophenone, 2,2-dimethoxyacetophenone, 4-(phenylthio)acetophenone, and 1,1-dichloroacetophenone, benzil, benzil ketals, such as benzil dimethyl ketal, and benzil diethyl ketal, anthraquinones, such as 2-methylanthraquinone, 2-ethylanthraquinone, 2-tert-butylanthraquinone, 1-chloroanthraquinone, and 2-amylanthraquinone, also triphenylphosphine, benzoylphosphine oxides, such as, for example, 2,4,6-trimethylbenzoyldiphenylphosphine oxide (Lucirin® TPO), benzophenones, such as benzophenone, and 4,4'-bis(N,N'-dimethylamino)benzophenone, thioxanthones and xanthones, acridine derivatives, phenazene derivatives, quinoxaline derivatives or 1-phenyl-1,2-propanedione-2-O-benzoyloxime, 1-aminophenyl ketones or 1-hydroxyphenyl ketones, such as 1-hydroxycyclohexyl phenyl ketone, phenyl (1-hydroxyisopropyl)ketone and 4-isopropylphenyl(1-hydroxyisopropyl)ketone, or triazine compounds, for example, 4'methyl thiophenyl-1-di(trichloromethyl)-3,5 S-triazine, S-triazine-2-(stylbene)-4,6-bis-trichloromethyl, and paramethoxy stiryl triazine, all of which are known compounds.

Especially suitable free-radical photoinitiators are acetophenones, such as 2,2-dialkoxybenzophenones and 1-hydroxyphenyl ketones, for example 1-hydroxycyclohexyl phenyl ketone, 2-hydroxy-1-{4-(2-hydroxyethoxy)phenyl}-2-methyl-1-propane, or 2-hydroxyisopropyl phenyl ketone (also called 2-hydroxy-2,2-dimethylacetophenone), but especially 1-hydroxycyclohexyl phenyl ketone. These photoinitiators are normally used in combination with a He/Cd laser, operating at for example 325 nm, an Argon-ion laser, operating at for example 351 nm, or 351 and 364 nm, or 333, 351, and 364 nm, or a frequency tripled YAG solid state laser, having an output at 355 nm, as the radiation source. Other especially suitable classes of free-radical photoinitiators comprise the benzil ketals and benzoylphosphine oxides. Especially an alpha-hydroxyphenyl ketone, benzil dimethyl ketal, or 2,4,6-trimethylbenzoyldiphenylphosphine oxide are used as photo-initiators.

Another class of suitable free radical photoinitiators comprises the ionic dye-counter ion compounds, which are capable of absorbing actinic rays and producing free radicals, which can initiate the polymerization of the acrylates. The compositions according to the invention that comprise ionic dye-counter ion compounds can thus be cured in a more variable manner using visible light in an adjustable wavelength range of 400 to 700 nanometers. Ionic dye-counter ion compounds and their mode of action are known, for example from published European-patent application EP 223587 and U.S. Patent Nos. 4,751,102; 4,772,530 and 4,772,541.

Especially preferred are the free-radical photoinitiators 1-hydroxycyclohexylphenyl ketone, which is commercially available as Irgacure I-184 and 2,4,6-trimethylbenzoyldiphenylphosphine oxide (Lucirin® TPO),

The free-radical initiators constitute from about 0.1 % to about 7% by weight, most preferably, from about 0.5% to about 5% by weight, of the total radiation curable composition.

### (C) Silica Nanoparticle Filler

Any type of silica-type (or silicon dioxide-type) nanoparticle can be employed in the present invention. The preferred type of silica-type nano-particles are commercially available from Hanse Chemie of Geesthacht, Germany. The preferred Hanse Chemie silica-type nanoparticle products are presuspended in an epoxy resin or a (meth)acrylate resin. The most preferred Hanse Chemie products are Nanopox XP22/0314 (which is 3,4-epoxycyclohexyl-3',4'-epoxycyclohexane carboxylate containing 40% nano-silica); Nanocryl XP21/0768 (hexanedioldiacrylate containing 50 wt. % nano-silica); Nanocryl XP 21/0687 (aliphatic urethanediacrylate containing 50 wt. % nano-silica); Nanocryl XP 21/0765 (cyclic trimethylol propane formal acrylate containing 50 wt. % nano-silica); Nanocryl XP 21/0746 (hydroxymethyl methacrylate, containing 50 wt. % nano-silica); Nanocryl XP21/1045 (trimethylol propane triacrylate containing 50 wt. % nano-silica) and Nanocryl XP 21/0930 (polyestertetraacrylate containing 50 wt. % nano-silica). The silicon dioxide nanoparticles suspended in these products have a very narrow particle size distribution of about 10 to about 50 nm, and are preferably spherical are not agglomerated and are surface modified.

Preferably, the amount of nanoparticles in these resin compositions will range from about 15% to about 60% by weight of the total resin composition; more preferably, from about 20% to about 50% by weight.

These silica nanoparticles may be made by any suitable method. Examples of such methods are discussed in an European Coating Journal (April 2001) article by T. Adebahr, C. Roscher and J. Adam entitled "Reinforcing Nanoparticles in Reactive Resins".

These nanoparticles can be initially suspended in either epoxy resins or (meth)acrylate resins or other components (as illustrated by the above-noted Hanse Chemie products) before being mixed with other components.

### (D) Cationically Polymerizable Organic Substances

The cationically polymerizable compound may expeditiously be an aliphatic, alicyclic or aromatic polyglycidyl compound or cycloaliphatic polyepoxide or epoxy cresol novolac or epoxy phenol novolac compound and which on average possess more than one epoxide group (oxirane ring) in the molecule. Such resins may have an aliphatic, aromatic, cycloaliphatic, araliphatic or heterocyclic structure; they contain epoxide groups or side groups or these groups form part of an alicyclic or hetrocyclic ring system. Epoxy resins of these types are known in general terms and are commercially available.

Examples of such suitable epoxy resins are disclosed in U.S. Patent No. 6,100,007.

Also conceivable is the use of liquid prereacted adducts of epoxy resins, such as those mentioned above, with hardeners for epoxy resins.

It is of course also possible to use liquid mixtures of liquid or solid epoxy resins in the novel compositions.

Examples of other cationically polymerizable organic substances other than epoxy resin compounds that may be used herein include oxetane compounds, such as trimethylene oxide, 3,3-dimethyloxetane and 3,3-dichloromethyloxethane, 3-ethyl-3-phenoxymethyloxetane, and bis(3-ethyl-3-methyloxy) butane; oxolane compounds, such as tetrahydrofuran and 2,3-dimethyl-tetrahydrofuran; cyclic acetal compounds, such as trioxane, 1,3-dioxalane and 1,3,6-trioxan cycloctane; cyclic lactone compounds, such as β-propiolactone and ε-caprolactone; thiirane compounds, such as ethylene sulfide, 1,2-propylene sulfide and thioepichlorohydrin; and thiotane compounds, such as 1,3-propylene sulfide and 3,3-dimethylthiothane.

Examples of such other cationically polymerizable compounds are also disclosed in U.S. Patent No. 6,100,007.

Preferably, the cationically polymerizable compounds of the present invention constitute about 10% to 40% by weight of the radiation-curable composition.

### (E) Cationic Polymerization Initiators

In the compositions according to the invention, any type of cationic photoinitiator that, upon exposure to actinic radiation, forms cations that initiate the reactions of the epoxy material(s) is used. There are a large number of known and technically proven cationic photoinitiators for epoxy resins that are suitable. They include, for example, onium salts with anions of weak nucleophilicity. Examples are halonium salts, iodosyl salts or sulfonium salts, such as described in published European patent application EP 153904, sulfoxonium salts, such as described, for example, in published European patent applications EP 35969;
EP 44274; EP 54509; and EP 164314, or diazonium salts, such as described, for example, in U.S. Patent Nos. 3,708,296 and 5,002,856. Other cationic photoinitiators are metallocene salts, such as described, for example, in published European applications EP 94914 and EP 94915. Other preferred cationic photoinitiators are mentioned in U.S. Patent Nos. 5,972,563 (Steinmann et al.); 6,100,007 (Pang et al.) and 6,136,497 (Melisaris et al.).

More preferred commercial cationic photoinitiators are UVI-6974, UVI-6976, UVI-6990 (manufactured by Union Carbide Corp.), CD-1010, CD-1011, CD-1012 (manufactured by Sartomer Corp.), Adekaoptomer SP-150, SP-151, SP-170, SP-171 (manufactured by Asahi Denka Kogyo Co., Ltd.), Irgacure 261 (Ciba Specialty Chemicals Corp.), CI-2481, CI-2624, CI-2639, CI-2064 (Nippon Soda Co., Ltd.), DTS-102, DTS-103, NAT-103, NDS-103, TPS-103, MDS-103, MPI-103, BBI-103 (Midori Chemical Co., Ltd.). Most preferred are UVI-6974, CD-1010, UVI-6976, Adekaoptomer SP-170, SP-171, CD-1012, and MPI-103. The above mentioned cationic photo-initiators can be used either individually or in combination of two or more.

The most preferred cationic photoinitiator is a triarylsulfonium hexafluoroantemonate such as UVI-6974 (from Union Carbide).

The cationic photoinitiators may constitute from about 0.1 % to about 8% by weight, more preferably, from about 0.5% to about 5% by weight, of the total radiation-curable composition.

### (F) Hydroxyl-Functional Compounds

These hydroxyl-functional compounds may be any organic material having a hydroxyl functionality of at least 1, and preferably at least 2. The material may be liquid or solid that is soluble or dispersible in the remaining components. The material should be substantially free of any groups which inhibit the curing reactions, or which are thermally or photolytically unstable.

Preferably, the hydroxyl-functional compounds are either aliphatic hydroxyl functional compounds or aromatic hydroxyl functional compounds.

The aliphatic hydroxyl functional compounds that may be useful for the present compositions include any aliphatic-type compounds that contain one or more reactive hydroxyl groups. Preferably these aliphatic hydroxyl functional compounds are multifunctional compounds (preferably with 2-5 hydroxyl functional groups) such as multifunctional alcohols, polyether-alcohols and polyesters.

Preferably the organic material contains two or more primary or secondary aliphatic hydroxyl groups. The hydroxyl group may be internal in the molecule or terminal. Monomers, oligomers or polymers can be used. The hydroxyl equivalent weight, i.e., the number average molecular weight divided by the number of hydroxyl groups, is preferably in the range of about 31 to 5000.

Representative examples of suitable organic materials having a hydroxyl functionality of 1 include alkanols, monoalkyl ethers of polyoxyalkyleneglycols, monoalkyl ethers of alkylene-glycols, and others.

Representative examples of useful monomeric polyhydroxy organic materials include alkylene glycols and polyols, such as 1,2,4-butanetriol; 1,2,6- hexanetriol; 1,2,3-heptanetriol, 2,6-dimethyl-1,2,6-hexanetriol; 1,2,3-hexanetriol; 1,2,3-butanetriol; 3-methyl-1,3,5-pentanetriol; 3,7,11,15-tetramethyl-1,2,3-hexadecanetriol; 2,2,4,4-tetramethyl-1,3-cyclobutanediol; 1,3-cyclopentanediol; trans-1,2-cyclooctanediol; 1,16-hexadecanediol; 1,3-propanediol; 1,4-butanediol; 1,5-pentanediol; 1,6-hexanediol; 1,7-heptanediol; 1,8-octanediol and 1,9-nonanediol.

Representative examples of useful oligomeric and polymeric hydroxyl-containing materials include polyoxyethylene and polyoxypropylene glycols and triols of molecular weights from about 200 to about 10,000; polytetramethylene glycols of varying molecular weight; copolymers containing pendant hydroxyl groups formed by hydrolysis or partial hydrolysis of vinyl acetate copolymers, polyvinylacetal resins containing pendant hydroxyl groups; hydroxyl-terminated polyesters and hydroxyl-terminated polylactones; hydroxyl-functionalized and polyalkadienes, such as polybutadiene; and hydroxyl-terminated polyethers. Other hydroxyl-containing monomers are 1,4-cyclohexanedimethanol and aliphatic and cycloaliphatic monohydroxy alkanols.

Other hydroxyl-containing oligomers and polymers include hydroxyl and hydroxyl/epoxy functionalized polybutadiene, polycaprolactone diols and triols, ethylene/butylenes polyols, and combinations thereof. Examples of polyether polyols are also polypropylene glycols of various molecular weights and glycerol propoxylate-B-ethoxylate triol, as well as linear and branched polytetrahydrofuran polyether polyols available in various molecular weights, such as for example 250, 650, 1000, 2000, and 2900 MW.

Preferred hydroxyl functional compounds are for instance simple multifunctional alcohols, polyether-alcohols, and/or polyesters. Suitable examples of multifunctional alcohols are trimethylolpropane, trimethylolethane, pentaeritritol, di-pentaeritritol, glycerol, 1,4-hexanediol and 1,4-hexanedimethanol and the like.

Suitable hydroxyfunctional polyetheralcohols are, for example, alkoxylated trimethylolpropane, in particular the ethoxylated or propoxylated compounds, polyethyleneglycol-200 or -600 and the like.

Suitable polyesters include hydroxyfunctional polyesters from diacids and diols with optionally small amounts of higher functional acids or alcohols. Suitable diols are those described above. Suitable diacids are, for example, adipic acid, dimer acid, hexahydrophthalic acid, 1,4-cyclohexane dicarboxylic acid and the like. Other suitable ester compounds include caprolactone based oligo- and polyesters such as the trimethylolpropane-triester with caprolactone, Tone®301 and Tone®310 (Union Carbide Chemical and Plastics Co., or UCCPC). The ester based polyols preferably have a hydroxyl number higher than about 50, in particular higher than about 100. The acid number preferably is lower than about 10, in particular lower than about 5. The most preferred aliphatic hydroxyl functional compound is trimethylolpropane, which is commercially available.

The aromatic hydroxyl functional compounds that may be useful for the present compositions include aromatic-type compounds that contain one or more reactive hydroxyl groups. Preferably these aromatic hydroxyl functional compounds would include phenolic compounds having at least 2 hydroxyl groups as well as phenolic compounds having at least 2 hydroxyl groups which are reacted with ethylene oxide, propylene oxide or a combination of ethylene oxide and propylene oxide.

The most preferred aromatic functional compounds include bisphenol A, bisphenol S, ethoxylated bisphenol A, ethoxylated bisphenol S.

These hydroxyl functional compounds are preferably present from about 1% to about 10% by weight, more preferably, from about 2% to about 5% by weight, of the total liquid radiation-cured composition.

### (G) Other Filler Materials

Besides the critical silica-type nanoparticles, the compositions of the present invention may also optionally contain other conventional micro filler materials previously used in stereolithographic resin compositions.

Such conventional fillers include micron-size silane coated silicas. One preferred silane coated silica is Silbond 600 MST (which has an average particle size of 4 microns).

If used, such additional micro fillers may constitute from about 1% to about 60% by weight of the resin composition; more preferably from about 5% to about 50% by weight of the resin composition.

### (H) Optional Additives

If necessary, the resin composition for stereolithography applications according to the present invention may contain other materials in suitable amounts, as far as the effect of the present invention is not adversely affected. Examples of such materials include radical-polymerizable organic substances other than the aforementioned cationically polymerizable organic substances; heat-sensitive polymerization initiators, various additives for resins such as coloring agents such as pigments and dyes, antifoaming agents, leveling agents, thickening agents, flame retardant and antioxidant.

### Formulation Preparation

The novel compositions can be prepared in a known manner by, for example, premixing individual components and then mixing these premixes, or by mixing all of the components using customary devices, such as stirred vessels, in the absence of light and, if desired, at slightly elevated temperature.

One preferred liquid radiation-curable composition useful for the production of three dimensional articles by stereolithography is defined in claim 17.

### Process of Masking Cured Three-Dimensional Articles

The novel compositions can be polymerized by irradiation with actinic light, for example by means of electron beams, X-rays, UV or VIS light, preferably with radiation in the wavelength range of 280-650 nm in conventional stereolithographic apparatus. Particularly suitable are laser beams of HeCd, argon or nitrogen and also metal vapor and NdYAG lasers. This invention is extended throughout the various types of lasers existing or under development that are to be used for the stereolithography process, e.g., solid state, argon ion, helium cadmium lasers, and the like. The person skilled in the art is aware that it is necessary, for each chosen light source, to select the appropriate photoinitiator and, if appropriate, to carry out sensitization. It has been recognized that the depth of penetration of the radiation into the composition to be polymerized, and also the operating rate, are directly proportional to the absorption coefficient and to the concentration of the photoinitiator. In stereolithography it is preferred to employ those photoinitiators which give rise to the highest number of forming free radicals or cationic particles.

One specific embodiment of the above mentioned method is a process for the stereolithographic production of a three-dimensional shaped article, in which the article is built up from a novel composition with the aid of a repeating, alternating sequence of steps (a) and (b); in step (a) a layer of the composition, one boundary of which is the surface of the composition, is cured with the aid of appropriate radiation within a surface region which corresponds to the desired cross-sectional area of the three-dimensional article to be formed, at the height of this layer, and in step (b) the freshly cured layer is covered with a new layer of the liquid, radiation-curable composition, this sequence of steps (a) and (b) being repeated until an article having the desired shape is formed. In this process, the radiation source used is preferably a laser beam, which with particular preference is computer-controlled.

In general, the above-described initial radiation curing, in the course of which the so-called green models are obtained which do not as yet exhibit adequate strength, is followed then by the final curing of the shaped articles by heating and/or further irradiation.

The present invention is further described in detail by means of the following Examples and Comparisons. All parts and percentages are by weight and all temperatures are degrees Celsius unless explicitly stated otherwise.

### EXAMPLES

The trade names of the components as indicated in the Examples 1-6 and Comparison Example 1 below correspond to the chemical substances as recited in the following Table 1.

**Table 1**

| Trade Name | Chemical Designation |
|---|---|
| UVACure 1500 | 3,4-epoxycyclohexylmethyl-3',4'-epoxycyclohexane-carboxylate |
| CYRACURE UVR 6110 | 3,4-epoxycyclohexylmethyl-3',4'-epoxycyclohexane-carboxylate |
| Araldite DY-T | trimethylolpropane triglycidylether |
| Voranol CP450 | glycerine propoxylated polyethertriol with an average molecular weight of 450 |
| Ebecryl 3700 | bisphenol A - diglycidylether diacrylate |
| Sartomer SR 399 | dipentaerythritol monohydroxy-pentaacrylate |
| Irgacure I-184 | 1-hydroxycyclohexyl phenyl ketone |
| Cyracure UVI - 6974 | triarylsulfonium hexafluoroantimonate |
| TMP | trimethylolpropane |
| Nanopox XP22/0314 | 3,4-epoxycyclohexyl-3',4'-epoxycyclohexane carboxylate containing 40% nano-silica |
| Nanocryl XP 21/0768 | Hexanedioldiacrylate containing 50% nano-silica |
| Silbond 600 MST | Micron-size silane coated silica (average particle size 4 microns) |
| Nanocryl XP 21/0687 | aliphatic urethanediacrylate, containing 50% nano-silica |
| Nanocryl XP 21/0765 | cyclic trimethylol propane formal acrylate, containing 50% nano-silica |
| Nanocryl XP 21/0746 | hydroxymethyl methacrylate, containing 50% nano-silica |
| Nanocryl XP 21/1045 | trimethylol propane triacylate, containing 50% nano-silica |
| Nanocryl XP 21/0930 | polyestertetraacrylate containing 50 wt% nano-silica |
| Lucirin TPO | 2,4,6-trimethylbenzoyl-diphenylphosphine oxide |

The formulations indicated in the Examples and Comparison Example below were prepared by mixing the components with a stirrer at 35 to 60°C until a homogeneous composition was obtained. The physical data relating to these formulations was obtained as follows:

The viscosity of each formulation was determined at 30°C using a Brookfield viscometer.

The photosensitivity of the liquid formulations was determined using the so-called Windowpane technique. In this determination, single-layer test specimens were produced using different laser energies, and the layer thicknesses obtained were measured. The plotting of the resulting layer thickness on a graph against the logarithm of the irradiation energy used gave a "working curve." The slope of this curve is termed Dp (given in mm or mils). The energy value at which the curve passes through the x-axis is termed Ec (and is the energy at which gelling of the material still just takes place; cf. P. Jacobs, Rapid Prototyping and Manufacturing, Soc. of Manufacturing Engineers, 1992, p. 270 ff.).

The measured post-cure mechanical properties of the formulations were determined on three-dimensional specimens produced stereolithographically with the aid of a Nd-Yag-laser. The stereolithographic equipment used was a Viper Si2 SLA system available from 3D Systems of Valencia, California. The laser power employed was about 80 milliwatts. The individual layers were about 0.1 millimeter thick. The specimens used for mechanical properties measurements were in the shape of tensile or flex bars (80 mm long x 4 mm wide x 2 mm thick). Other cured parts were produced, including cylindrically shaped electronic connectors having fine detailed features.

The Glass Transition temperatures of each formulation were determined by the TMA" method " (thermomechanical analysis).

The Tensile Modulus (MPa), Tensile Strength (MPa) and Elongation at Break (%) were all determined according to the ISO 527 method. The Impact Resistance (notched, kJ/m²) was determined according to the ISO 179 method. The hardness of the cured resins was determined according to the Shore D test.

### EXAMPLE 1, not falling under the claimed invention.

The following components were mixed to produce a homogeneous liquid composition:

| Component | Percentage (by weight) |
|---|---|
| Nanocryl XP 21/0687 | 50 |
| Nanocryl XP 21/0765 | 20 |
| Nanocryl XP 21/1045 | 24 |
| Irgacure I-184 | 4 |
| Lucirin TPO | 2 |
| | 100 |
| | |
| Total Filler Concentration | 47% |
| Filler Conc. - Nanoparticles | 47% |
| Filler Conc. - Microparticles | 0% |

### EXAMPLE 2

The following components were mixed to produce a homogeneous liquid composition:

| Component | Percentage (by weight) |
|---|---|
| UVR 6110 | 27 |
| Araldite DY-T | 10 |
| Voranol CP 450 | 6 |
| UVI 6974 | 4 |
| Irgacure I-184 | 3 |
| XP 21/0930 | 50 |
| | 100 |
| | |
| Total Filler Concentration | 25% |
| Filler Conc. - Nanoparticles | 25% |
| Filler Conc. - Microparticles | 0% |

### EXAMPLE 3

The following components were mixed to produce a homogeneous liquid composition:

| Component | Percentage (by weight) |
|---|---|
| Nanopox XP 22/0314 | 53 |
| Voranol CP 450 | 5 |
| UVI 6974 | 4 |
| Irgacure 184 | 2 |
| Nanocryl XP 21/0768 | 36 |
| | 100 |
| | |
| Total Filler Concentration | 39% |
| Filler Conc. - Nanoparticles | 39% |
| Filler Conc. - Microparticles | 0% |

A transparent solution was obtained with a viscosity of 500 cps.

Heating the solution at 110°C during more than 8 hours didn't change the viscosity, nor the transparency.

### EXAMPLE 4

The following components were mixed to produce a homogeneous liquid composition:

| Component | Percentage (by weight) |
|---|---|
| Nanopox XP 22/0314 | 35.34 |
| Voranol CP450 | 3.33 |
| Nanocryl XP 21/0768 | 24 |
| UVI-6974 | 2.67 |
| Irgacure I-184 | 1.33 |
| Silbond 600 MST | 33.33 |
| | 100 |
| | |
| Total Filler Concentration | 59.3% |
| Filler Conc. - Nanoparticles | 26.0% |
| Filler Conc. - Microparticles | 33.3% |

### EXAMPLE 5

The following components were mixed to produce a homogeneous liquid composition:

| Component | Percentage (by weight) |
|---|---|
| Nanocryl XP 22/0314 | 26.5 |
| Voranol CP450 | 2.5 |
| Nanocryl XP 21/0768 | 18 |
| UVI-6974 | 2 |
| Irgacure I-184 | 1 |
| Silbond 600 MST | 50 |
| | 100 |
| | |
| Total Filler Concentration | 69.5% |
| Filler Conc. - Nanoparticles | 19.5% |
| Filler Conc. - Microparticles | 50.0% |

### EXAMPLE 6

The following components were mixed to produce a homogeneous liquid composition:

| Component | Percentage (by weight) |
|---|---|
| Nanocryl XP 22/0314 | 27.9 |
| Voranol CP450 | 2.63 |
| Nanocryl XP 21/0768 | 18.95 |
| UVI-6974 | 2.1 |
| Irgacure I-184 | 1.05 |
| Silbond 600 MST | 47.37 |
| | 100 |
| | |
| Total Filler Concentration | 68.0% |
| Filler Conc. - Nanoparticles | 20.64% |
| Filler Conc. - Microparticles | 47.37% |

### COMPARISON EXAMPLE 7

The following components were mixed to produce a homogeneous liquid composition:

| Component | Percentage (by weight) |
|---|---|
| UVAcure 1500 | 21.73 |
| Araldite DY-T | 13.5 |
| TMP | 0.9 |
| Sartomer 399 | 2.83 |
| Ebercryl 3700 | 2.66 |
| UVI-6974 | 2.25 |
| Irgacure I-184 | 1.13 |
| Silbond 600 MST | 55.0 |
| | 100 |
| | |
| Total Filler Concentration | 55% |
| Filler Conc. - Nanoparticles | 0% |
| Filler Conc. - Microparticles | 55% |

The measured photosensitivity and viscosity of these seven (7) formulations are shown in Table 2.

**Table 2**

| Resin Formulation Properties | | | | | | | |
|---|---|---|---|---|---|---|---|
| Property | Example | | | | | | |
| | 1 | 2 | 3 | 4 | 5 | 6 | CE-1 |
| Viscosity (30°C) | 2890 | 460 | 500 | 940 | 3720 | 2900 | 3160 |
| Dp (mils) | 4.1 | 7.3 | 6.1 | NM | NM | 4.8 | NM |
| E_{C} (mJ/cm²) | 1.64 | 10 | 10 | NM | NM | 3.5 | NM |
| E₆ | 7.09 | 22.75 | 26.74 | NM | NM | 12.2 | NM |
| E₁₂ | 30.64 | 51.75 | 71.5 | NM | NM | 42.64 | NM |
| NM-Not Measured | | | | | | | |

Examples 1 to 3 are formulations containing only nanosize silica fillers. They are transparent and have low to medium viscosities. Examples 4 to 6 contain mixtures of nanosize and microsize silica. They are not transparent and show some light scattering. In spite of their higher total filler concentration than Comparative Example (CE-1), Examples 5 and 6 are of similar viscosity to CE-1. Examples 4 to 6 stay homogeneous over a period of 2 weeks without stirring, whereas CE-1 forms a solid sediment which is difficult to stir up, after a period of about 1 week.

The measured mechanical properties of these seven formulations after curing are shown in Table 3.

**Table 3**

| Mechanical Properties After Postcuring | | | | | | | |
|---|---|---|---|---|---|---|---|
| Property | Example | | | | | | |
| | 1 | 2 | 3 | 4 | 5 | 6 | CE-1 |
| After 1 hour UV-curing: | | | | | | | |
| Flexural modulus (MPa) | 3722 | 1420 | 4375 | 8300 | 11000 | 12301 | 7648 |
| Shore D | NM | 88 | NM | NM | NM | 92 | 90 |

| After 1 hour UV-curing and 2 hours curing at 120°C: | | | | | | | |
|---|---|---|---|---|---|---|---|
| Flexural modulus (MPa) | NM | 4220 | 5460 | NM | 11400 | 11340 | 9771 (2hrs at 160°C) |
| Softening point by TMA (°C) | NM | NM | >200 °C | >200 °C | >200° C | >200° C | >200° C |

| After 1 hour UV-curing, 2 hours at 120°C and after exposure to 90% relative humidity: | | | | | | | |
|---|---|---|---|---|---|---|---|
| Flexural modulus (MPa) | NM | NM | 4787 (14 days) | NM | NM | 7800 (18 days) | NM |
| NM - Not Measured | | | | | | | |

The formulations containing only nano-size silica (Examples 1 to 3) have a flexural modulus of 3700 to 5500 MPa, whereas normal unfilled resins have flexural moduli of 3300 Mpa maximum. The individual formulations containing a mixture of nano- and micro-silica (Examples 4 to 6) have a flex modulus of 8000 to 12000 MPa and a softening point of more than 200°C.

While the invention has been described above with reference to specific embodiments thereof, it is apparent that many changes, modifications, and variations can be made without departing from the inventive concept disclosed herein. Accordingly, It is intended to embrace all such changes, modifications and variations that fall within the broad scope of the appended claims.

## Claims

1. A liquid radiation-curable composition useful for the production of three dimensional articles by stereolithography that comprises:
(a) at least one free-radical polymerizing organic substance;
(b) at least one free-radical polymerization initiator;
(c) at least one filler comprising silica-type particles suspended in the radiation-curable composition;
(d) at least one cationically polymerizing organic substance;
(e) at least one cationic polymerization initiator;
(f) at least one hydroxyl-functional compound from about 1% to about 10% by weight of the total liquid composition; and
(g) optionally, at least one type of microparticle filler **characterised in that** the silica-type particles are nano particles and said nanoparticles have a size distribution of 10 to 50 nanometers.

2. The composition of claim 1 wherein component (a) is at least one mono-, di-, tri-, tetra- or pentafunctional monomeric or oligomeric aliphatic, cycloaliphatic or aromatic (meth)acrylate.

3. The composition of claim 1 wherein component (a) comprises a mono-, di- or tri-functional aliphatic (meth)acrylate compound.

4. The composition of claim 1 wherein component (a) comprises a mono-functional aliphatic (meth)acrylate compound.

5. The composition of claim 1 wherein component (a) comprises a di-functional aliphatic (meth)acrylate compound or pentafunctional monomeric or oligomeric aliphatic, cycloaliphatic, or aromatic (meth)acrylate.

6. The composition of claim 1 wherein component (a) comprises a urethane (meth)acrylate.

7. The composition of any one of the preceding claims wherein component (a) constitutes from about 5% to about 50% by weight of the total liquid radiation-curable composition.

8. The composition of any one of the preceding claims wherein component (b) is 1-hydroxycyclohexyl phenyl ketone or 2,4,6-trimethylbenzoyldiphenylphosphine oxide or a mixture of both.

9. The composition of claim 8 wherein component (b) constitutes from about 0.1 to about 7% by weight of the total liquid radiation-curable composition.

10. The composition of claim 8 or claim 9 wherein component (c) nanoparticles are spherical, are not agglomerated, and are surface modified.

11. The composition of any one of claims 8 to 10 wherein component (c) constitutes from about 15% to about 60% by weight to the total resin composition.

12. The composition of any one of the preceding claims wherein component (d) comprises 3,4-epoxycyclohexylmethyl-3',4'-epoxycyclohexane carboxylate, or trimethylol propane triglycidylether.

13. The composition of claim 12 wherein component (d) constitutes from about 10% to about 40% by weight of the total liquid radiation-curable composition.

14. The composition of any one of the preceding claims wherein component (e) is triarylsulfonium hexafluoroantimonate.

15. The composition of claim 14 wherein component (e) constitutes from about 0.1 tao about 8% by weight of the total liquid radiation-curable composition.

16. The composition of claim **1,** wherein component (f) is trimethylol propane.

17. The composition of claim 1 wherein the composition comprises:
(a) at least one mono-, di-, tri-, tetra- or pentafunctional monomeric or oligomeric aliphatic, cycloaliphatic or aromatic (meth)acrylate;
(b) at least one free-radical polymerization initiator;
(c) at least one filler comprising silica nanoparticles suspended in the composition;
(d) at least one cationically polymerizing organic substance selected from the group consisting of 3,4-epoxycyclohexylmethyl-3',4'-epoxy-cyclohexane carboxylate, trimethylol propane triglycidylether and mixtures thereof;
(e) at least one cationic polymerization initiator;
(f) at least one hydroxyl-functional compound; and
(g) at least one microparticle filler.

18. A process for forming a three-dimensional article by stereolithography, said process comprising the steps:
(a) coating a thin layer of a liquid radiation-curable composition onto a surface said composition including at least one filler comprising silica-type nano-particles suspended in the radiation-curable composition;
(b) exposing said thin layer imagewise to actinic radiation to form an imaged cross-section, wherein the radiation is of sufficient intensity to cause substantial curing of the thin layer in the exposed areas;
(c) coating a thin layer of the composition onto the previously exposed imaged cross-section;
(d) exposing said thin layer from step (c) imagewise to actinic radiation to form an additional imaged cross-section, wherein the radiation is of sufficient intensity to cause substantial curing of the thin layer in the exposed areas and to cause adhesion to the previously exposed imaged cross-section;
(e) repeating steps (c) and (d) a sufficient number of times in order to build up the three-dimensional article; **characterised in that** the liquid radiation-curable composition is a composition according to any one of claims 1 to 17.

## Patentansprüche

1. Eine flüssige, strahlenaushärtbare Zusammensetzung, welche für die Herstellung dreidimensionaler Artikel durch Stereolithografie geeignet ist, aufweisend:
(a) zumindest eine frei-radikalische polymerisierende organische Substanz;
(b) zumindest ein frei-radikalischer Polymerisationsinitiator;
(c) zumindest ein Füller umfassend siliziumdioxidartige Partikel, welche in der strahlenaushärtbaren Zusammensetzung schweben;
(d) zumindest eine kationisch polymerisierende organische Substanz;
(e) zumindest ein kationischer Polymerisationsinitiator;
(f) zumindest eine Hydroxyl-funktionale Verbindung mit zumindest von etwa 1% bis etwa 10% nach Gewicht von der gesamten flüssigen Zusammensetzung; und
(g) optional, zumindest eine Art von Mikropartikelfüller,
**dadurch gekennzeichnet, dass** die siliziumdioxidartigen Partikel Nanopartikel sind und die Nanopartikel eine Größenverteilung von 10-50 nm aufweisen.

2. Die Zusammensetzung nach Anspruch 1, wobei die Komponente (a) zumindest ein mono-, di-, tri-, tetra- oder penta-funktionales monomerisches oder oligomeres aliphatisches, zykloaliphatisches oder aromatisches (meth)Acrylat ist.

3. Die Zusammensetzung nach Anspruch 1, wobei Komponente (a) eine mono-, di- oder tri-funktionale aliphatische (meth)Acrylatverbindung umfasst.

4. Die Zusammensetzung nach Anspruch 1, wobei Komponente (a) eine monofunktionale aliphatische (meth)Acrylatverbindung umfasst.

5. Die Zusammensetzung nach Anspruch 1, wobei Komponente (a) eine difunktionale aliphatische (meth)Acrylatverbindung oder pentafunktionales monomerisches oder oligomeres aliphatisches, zykloaliphatisches oder aromatisches (meth)Acrylat umfasst.

6. Die Zusammensetzung nach Anspruch 1, wobei Komponente (a) ein Uretan-(meth)Acrylat umfasst.

7. Die Zusammensetzung nach einem der vorhergehenden Ansprüche, wobei Komponente (a) von etwa 5% bis etwa 50% nach Gewicht von der gesamten flüssigen, strahlenaushärtbaren Zusammensetzung ausmacht.

8. Die Zusammensetzung nach einem der vorhergehenden Ansprüche, wobei Komponente (b) 1-Hydroxycyclohexyl-Phenyl-Keton oder 2,4,6-Trimethylbenzoyldiphenylphosphin-Oxid oder eine Mischung von beidem ist.

9. Die Zusammensetzung nach Anspruch 8, wobei Komponente (b) von etwa 0,1% bis etwa 7% nach Gewicht von der gesamten flüssigen, strahlenaushärtbaren Zusammensetzung ausmacht.

10. Die Zusammensetzung nach Anspruch 8 oder Anspruch 9, wobei die Nanopartikel von Komponente (c) kugelförmig sind, nicht agglomeriert sind, und oberflächenmodifiziert sind.

11. Die Zusammensetzung nach einem der Ansprüche 8-10, wobei Komponente (c) von etwa 15% bis etwa 60% nach Gewicht von der gesamten Harzzusammensetzung ausmacht.

12. Die Zusammensetzung nach einem der vorhergehenden Ansprüche, wobei Komponente (d) 3,4-Epoxycyclohexylmethyl-3',4'-Epoxycyclohexan-Carboxylat, oder Trimethylol-Propan-Triglycidylether umfasst.

13. Die Zusammensetzung nach Anspruch 12, wobei Komponente (d) von etwa 10% bis etwa 40% nach Gewicht von der gesamten flüssigen, strahlenaushärtbaren Zusammensetzung ausmacht.

14. Die Zusammensetzung nach einem der vorhergehenden Ansprüche, wobei Komponente (e) Triarylsulfonium-Hexafluoroantimonat ist.

15. Die Zusammensetzung nach Anspruch 14, wobei Komponente (e) von etwa 0,1% bis etwa 8% nach Gewicht von der gesamten flüssigen, strahlenaushärtbaren Zusammensetzung ausmacht.

16. Die Zusammensetzung nach Anspruch 1, wobei Komponente (f) Trimethylol Propan ist.

17. Die Zusammensetzung nach Anspruch 1, wobei die Zusammensetzung umfasst:
(a) zumindest ein mono-, di-, tri-, tetra- oder penta-funktionales monomerisches oder oligomerisches aliphatisches, cycloaliphatisches oder aromatisches (meth)Acrylat;
(b) zumindest ein frei-radikalischer Polymerisationsinitiator;
(c) zumindest ein Füller aufweisend Siliziumdioxid-Nanopartikel, welche in der Zusammensetzung schweben;
(d) zumindest eine kationisch polymerisierende organische Substanz welche von der folgenden Gruppe ausgewählt ist: 3,4-Epoxycyclohexylmethyl-3',4'-Epoxy-Cyclohexan-Carboxylat, Trimethylol-Propan-Triglycidylether und Mischungen hiervon;
(e) zumindest ein kationischer Polymerisationsinitiator:
(f) zumindest eine Hydroxyl-funktionale Verbindung, und
(g) zumindest ein Mikropartikelfüller.

18. Prozess zum Bilden eines dreidimensionalen Artikels mit Stereolithografie, wobei der Prozess folgende Schritte aufweist:
(a) Beschichten einer Oberfläche mit einer dünnen Schicht aus einer flüssigen, strahlenaushärtbaren Zusammensetzung, wobei die Zusammensetzung zumindest einen Füller umfasst, welcher siliziumdioxidartige Nanopartikel umfasst, die in der strahlenaushärtbaren Zusammensetzung schweben;
(b) bildweises Aussetzen der dünnen Schicht an aktinische Strahlung um einen abgebildeten Querschnitt zu bilden, wobei die Strahlung von ausreichender Intensität ist um ein substanzielles Aushärten der dünnen Schicht in den ausgesetzten Bereichen hervorzurufen;
(c) Beschichten des zuvor ausgesetzten abgebildeten Querschnitts mit einer dünnen Schicht der Zusammensetzung;
(d) bildweises Aussetzen der dünnen Schicht von Schritt (c) an aktinische Strahlung um einen zusätzlichen abgebildeten Querschnitt zu bilden, wobei die Strahlung von ausreichender Intensität ist um ein substantielles Aushärten der dünnen Schicht in den ausgesetzten Bereichen hervorzurufen und um Adhäsion zu dem zuvor ausgesetzten abgebildeten Querschnitt hervorzurufen;
(e) Wiederholen der Schritte (c) und (d) mit ausreichender Häufigkeit um den dreidimensionalen Artikel aufzubauen;
**dadurch gekennzeichnet, dass** die flüssige, strahlenaushärtbare Zusammensetzung eine Zusammensetzung gemäß einer der Ansprüche 1-17 ist.

## Revendications

1. Composition liquide durcissable par rayonnement, pouvant être utilisée pour la production d'articles tridimensionnels par stéréolithographie, qui comprend:
(a) au moins une substance organique polymérisable par polymérisation radicalaire;
(b) au moins un amorceur de polymérisation radicalaire;
(c) au moins une charge comprenant des particules de type silice en suspension dans une composition durcissable par rayonnement;
(d) au moins une substance organique polymérisable par polymérisation cationique;
(e) au moins un amorceur de polymérisation cationique;
(f) au moins un composé à fonctionnalité hydroxyle, en une quantité d'environ 1% à environ 10% en poids par rapport à la composition liquide totale; et
(g) en option, au moins un type de charge microparticulaire,
**caractérisée en ce que** les particules de type silice sont des nanoparticules, et que lesdites nanoparticules ont une distribution granulométrique de 10 à 50 nanomètres.

2. Composition selon la revendication 1, dans laquelle le composant (a) est au moins un (méth)acrylate aliphatique, cycloaliphatique ou aromatique, monomère ou oligomère, mono-, di-, tri-, tétra- ou pentafonctionnel.

3. Composition selon la revendication 1, dans laquelle le composant (a) comprend un composé (méth)acrylate aliphatique mono-, di- ou trifonctionnel.

4. Composition selon la revendication 1, dans laquelle le composant (a) comprend un composé (méth)acrylate aliphatique monofonctionnel.

5. Composition selon la revendication 1, dans laquelle le composant (a) comprend un composé (méth)acrylate aliphatique difonctionnel ou un (méth)acrylate aliphatique, cycloaliphatique ou aromatique, monomère ou oligomère, pentafonctionnel.

6. Composition selon la revendication 1, dans laquelle le composant (a) comprend un (méth)acrylate d'uréthanne.

7. Composition selon l'une quelconque des revendications précédentes, dans laquelle le composant (a) constitue d'environ 5% à environ 50% en poids de la composition liquide totale durcissable par rayonnement.

8. Composition selon l'une quelconque des revendications précédentes, dans laquelle le composant (b) est la 1-hydroxycyclohexyl-phényl-cétone ou l'oxyde de 2,4,6-triméthylbenzoldiphénylphosphine, ou un mélange des deux.

9. Composition selon la revendication 8, dans laquelle le composant (b) constitue d'environ 0,1 à environ 7 % en poids de la composition liquide totale durcissable par rayonnement.

10. Composition selon la revendication 8 ou la revendication 9, dans laquelle les nanoparticules du composant (c) sont sphériques, ne sont pas agglomérées et sont modifiées en surface.

11. Composition selon l'une quelconque des revendications 8 à 10, dans laquelle le composant (c) constitue d'environ 15 % à environ 60 % en poids de la composition de résine totale.

12. Composition selon l'une quelconque des revendications précédentes, dans laquelle le composant (d) comprend du 3',4'-époxycyclohexanecarboxylate de 3,4-époxycyclohexylméthyle, ou de l'éther triglycidylique du triméthylolpropane.

13. Composition selon la revendication 12, dans laquelle le composant (d) constitue d'environ 10% à environ 40% en poids de la composition liquide totale durcissable par rayonnement.

14. Composition selon l'une quelconque des revendications précédentes, dans laquelle le composant (e) est l'hexafluoroantimoniate de triarylsulfonium.

15. Composition selon la revendication 14, dans laquelle le composant (e) constitue d'environ 0,1. à environ 8 % en poids de la composition liquide totale durcissable par rayonnement.

16. Composition selon la revendication 1, dans laquelle le composant (f) est le triméthylolpropane.

17. Composition selon la revendication 1, la composition comprenant:
(a) au moins un (méth)acrylate aliphatique, cycloaliphatique ou aromatique, monomère ou oligomère, mono-, di-, tri-, tétra- ou pentafonctionnel;
(b) au moins un amorceur de polymérisation radicalaire;
(c) au moins une charge comprenant des nanoparticules de silice en suspension dans la composition;
(d) au moins une substance organique polymérisable par polymérisation cationique, choisie dans le groupe consistant en le 3',4'-époxycyclohexanecarboxylate de 3,4-époxycyclohexylméthyle, l'éther diglycidylique du triméthylolpropane, et les mélanges de ceux-ci;
(e) au moins un amorceur de polymérisation cationique;
(f) au moins un composé à fonctionnalité hydroxyle; et
(g) au moins une charge microparticulaire.

18. Procédé de formation d'un article tridimensionnel par stéréolithographie, ledit procédé comprenant les étapes de:
(a) application d'une couche mince d'une composition liquide durcissable par rayonnement sur une surface, ladite composition comprenant au moins une charge comprenant des nanoparticules de type silice en suspension dans la composition durcissable par rayonnement;
(b) exposition de ladite couche mince, selon l'image, à un rayonnement actinique pour former une section transversale imagée, le rayonnement ayant une intensité suffisante pour provoquer un durcissement important de la couche mince dans les zones exposées;
(c) application d'une couche mince de la composition sur la section transversale imagée préalablement exposée;
(d) exposition de ladite couche mince de l'étape (c) selon l'image à un rayonnement actinique pour former une section transversale imagée additionnelle, le rayonnement ayant une intensité suffisante pour provoquer un durcissement important de la couche mince dans les zones exposées et pour provoquer une adhérence à la section transversale imagée préalablement exposée;
(e) répétition des étapes (c) et (d) un nombre suffisant de fois dans le but de construire l'article tridimensionnel;
**caractérisé en ce que** la composition liquide durcissable par rayonnement est une composition selon l'une quelconque des revendications 1 à 17.
